Europäisches Patentamt

European Patent Office

Office européen des brevets

(11) Veröffentlichungsnummer: **0 176 753**

**A1**

## (12) EUROPÄISCHE PATENTANMELDUNG

(21) Anmeldenummer: 85110689.8

(22) Anmeldetag: 26.08.85

(51) Int. Cl.4: **H01L 27/08** , H01L 27/06

(30) Priorität: 27.09.84 DE 3435547

(43) Veröffentlichungstag der Anmeldung:
09.04.86 Patentblatt 86/15

(84) Benannte Vertragsstaaten:
DE FR GB IT NL SE

(71) Anmelder: Siemens Aktiengesellschaft
Berlin und München Wittelsbacherplatz 2
D-8000 München 2(DE)

(72) Erfinder: Herberg, Helmut, Dr.Dipl.-Phys.
Bruderhofstrasse 30a
D-8000 München 70(DE)

(54) Darlington-Schaltung mit einem Feldeffekttransistor und einen bipolaren Ausgangstransistor.

㉗ Restspannung, die zwischen dem Emitter- und dem Kollektoranschluß (5 und 7) des Ausgangstransistors im stromführenden Zustand abfällt. Das wird dadurch erreicht, daß der Emitter des Ausgangstransistors aus einer Mehrzahl von Emittergebieten (3, 14) des ersten Leitfähigkeitstyps besteht, die in eine Mehrzahl von inselförmigen Halbleitergebieten (2, 18) des zweiten Leitfähigkeitstyps eingefügt sind, welche damit als Basisgebiete des Ausgangstransistors dienen. Der laterale Abstand zwischen einem Emittergebiet (3) und einem in demselben inselförmigen Halbleitergebiet (2) vorgesehenen Sourcegebiet (8) des Feldeffekttransistors ist kleiner gewählt als die Dicke des Halbleiterkörpers zwischen seinen Hauptflächen (1a, 1b), die mit Kontakten für den Emitteranschluß (5) und den Kollektoranschluß (7) versehen sind. Der Anwendungsbereich umfaßt Geräte der Leistungselektronik.

Darlington-Schaltung mit einem Feldeffekttransistor und einem bipolaren Ausgangstransistor

Die Erfindung bezieht sich auf eine Darlington-Schaltung mit einem Feldeffekttransistor und einem bipolaren Ausgangstransistor nach dem Oberbegriff des Patentanspruchs 1.

Eine solche Schaltung ist z.B. aus dem Aufsatz "Power Bipolar Devices" von Ph. Leturcq in der Zeitschrift "Microelectronic" Reliab., Bd. 24, No. 2, 1982, S. 313-337, insbesondere Fig. 18 auf S. 335, bekannt. Neben einem das Sourcegebiet des Feldeffekttransistors aufnehmenden inselförmigen Halbleitergebiet ist hier ein weiteres solches Gebiet des zweiten Leitfähigkeitstyps vorgesehen, in das ein Emittergebiet des Ausgangstransistors eingebettet ist, das über einen Emitterkontakt mit dem Emitteranschluß verbunden ist. Die Dicke des Halbleiterkörpers ist dabei kleiner gewählt als der laterale Abstand des Draingebietes des Feldeffektransistors vom Emittergebiet des Ausgangstransistors, wobei das Draingebiet durch einen Teilbereich des Halbleiterkörpers gebildet wird, der unmittelbar an die von der Gateelektrode überdeckte Randzone des inselförmigen Gebiets angrenzt.

Aufgabe der vorliegenden Erfindung ist es, eine Darlington-Schaltung der eingangs genannten Art anzugeben, bei der unter sonst gleichen Bedingungen im stromführenden Zustand eine wesentlich niedrigere Restspannung zwischen dem Emitter- und dem Kollektoranschluß vorhanden ist, als bei der vorstehend erwähnten, bekannten Darlington-Schaltung. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß die Draingebiete des Feldeffekttransistors, welche aus Teilbereichen des Halbleiterkörpers bestehen, die unmittelbar an die von den Gateelektroden überdeckten Randzonen der inselförmigen Gebiete angrenzen, eine wesentlich größere Leitfähigkeit aufweisen, als dies bei der bekannten Schaltung der Fall ist. Die Ursache hierfür ist darin zu sehen, daß im stromführenden Zustand der Darlington-Schaltung unterhalb der Emittergebiete des in der Sättigung oder Quasisättigung betriebenen Ausgangstransistors Speicherladungen auftreten, die sich bis in die genannten Draingebiete hinein erstrecken. Damit verringert sich aber bei sonst gleichen Verhältnissen, insbesondere bei der Einspeisung eines gleichgroßen Basisstroms, die zwischen dem Emitteranschluß und dem Kollektoranschluß abfallende Restspannung. Andererseits ergibt sich für eine vergleichbare Restspannung ein wesentlich größerer Basisstrom und damit ein größerer, an einen zwischen den Emitteranschluß und den Kollektoranschluß geschalteten Laststromkreis abzugebender maximaler Kollektorstrom, als bei der bekannten Darlington-Schaltung.

Die Ansprüche 2 bis 8 betreffen bevorzugte Ausgestaltungen und Weiterbildungen der Erfindung.

Die Erfindung wird nachfolgend anhand der Zeichnung näher erläutert. Dabei zeigen:

Fig. 1 ein erstes Ausführungsbeispiel der Erfindung,

Fig. 2 ein zweites Ausführungsbeispiel und die

Fig. 3 und 4 bevorzugte Weiterbildungen der Erfindung.

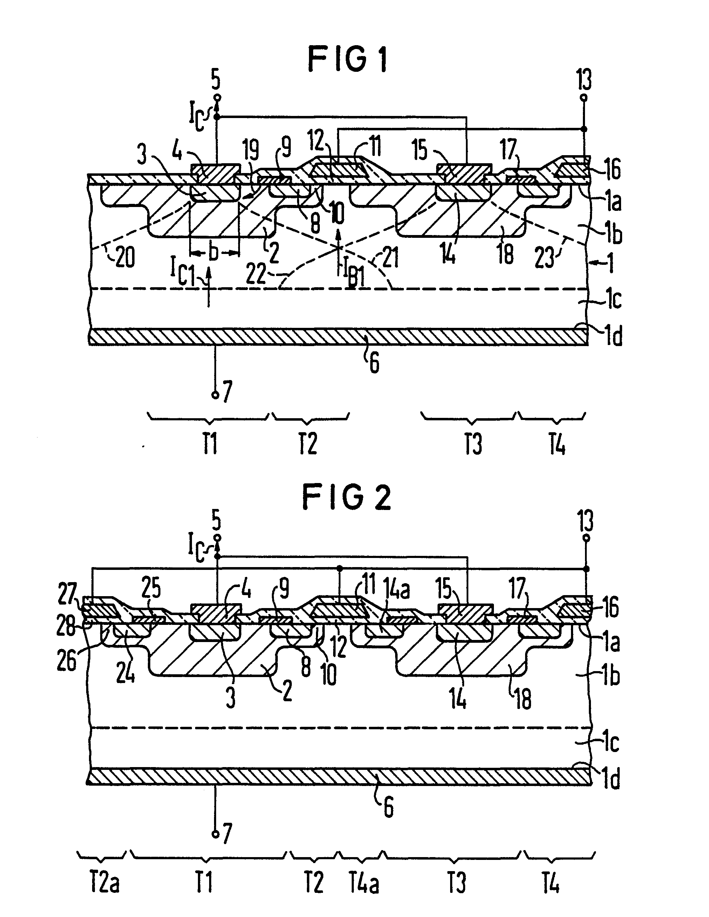

In Fig. 1 ist ein Teil eines scheibenförmigen Körpers 1 aus dotiertem Halbleitermaterial, z.B. Silizium, im Querschnitt dargestellt. Er enthält eine $n^-$-dotierte Schicht 1b, die sich bis zu einer ersten Hauptfläche 1a erstreckt und eine unterhalb derselben liegende $n^+$-dotierte Schicht 1c, die von einer zweiten Hauptfläche 1d des Halbleiterkörpers begrenzt wird. Für die Schichten 1b und 1c können z.B. folgende Dotierungskonzentrationen n vorgesehen sein: $n_{1b}$

$= 10^{14} cm^{-3}$, $n_{1c} = 2 \cdot 10^{18} cm^{-3}$. Ein Teil der Schichten 1b und 1c bildet den Kollektor eines bipolaren npn-Transistors T1, dessen Basis aus einem p-leitenden inselförmigen Halbleitergebiet 2 besteht, das in den Halbleiterkörper 1 so eingefügt ist, daß es sich bis zur Hauptfläche 1a erstreckt. In das Gebiet 2 ist ein n-leitendes Emittergebiet 3 eingefügt, das in der Hauptfläche 1a mit einem Emitterkontakt 4 versehen ist, der an einen Emitteranschluß 5 gelegt ist. Die Dotierungskonzentration von 3 kann an der Hauptfläche 1a etwa $5 \cdot 10^{20} cm^{-3}$ betragen, wobei die Dotierungskonzentration des Halbleitergebiets 2 an der Grenze zum Emittergebiet 3 z.B. $10^{17} cm^{-3}$ beträgt. Die Schicht 1c ist in der zweiten Hauptfläche 1b mit einem Kollektorkontakt 6 versehen, der an einen Kollektoranschluß 7 geführt ist.

In das inselförmige Halbleitergebiet 2 ist das n-leitende Sourcegebiet 8 eines n-Kanal-Feldeffekttransistors T2 eingefügt, das sich ebenfalls bis zur Hauptfläche 1a erstreckt und in dieser mit einer leitenden Belegung 9 versehen ist, die in Richtung auf das Emittergebiet 3 so weit verlängert ist, daß es die laterale Begrenzung des Gebiets 8 überragt und das Gebiet 2 kontaktiert. Eine Randzone 10 des inselförmigen Gebiets 2, die sich bis an die Hauptfläche 1a und bis an den rechten Rand des Sourcegebiets 8 erstreckt, wird von einer Gateelektrode 11 überdeckt, die durch eine dünne elektrisch isolierende Schicht 12 von der Hauptfläche 1a getrennt ist und mit einem Gateanschluß 13 verbunden ist. Der an die Randzone 10 rechtsseitig angrenzende Teilbereich der Schicht 1b und ein unter diesem liegender, entsprechender Teilbereich der Schicht 1c bilden das Draingebiet von T2. Der Kollektoranschluß 7 stellt gleichzeitig den Drainanschluß von T2 dar. Das Sourcegebiet 8 ist seinerseits über die leitende Belegung 9 mit der Basis 2 des bipolaren Transistors T1 verbunden.

Neben der bisher beschriebenen Transistorkombination T1, T2 enthält der Halbleiterkörper 1 noch n-1 weitere gleichartig aufgebaute Transistorkombinationen, von denen eine mit T3, T4 angedeutet ist. Das Emittergebiet 14 des bipolaren Transistors T3 ist dabei mit einem Emitterkontakt 15 versehen, der mit dem Emitteranschluß 5 verbunden ist. Das Gate 16 des Feldeffekttransistors T4 ist an den Gateanschluß 13 geschaltet, während der Kollektor von T3 und das Draingebiet von T4 an den Anschluß 7 gelegt sind. Das Sourcegebiet von T4 ist über eine leitende Belegung 17 mit der aus dem inselförmigen Gebiet 18 bestehenden Basis von T3 verbunden. Die übrigen, nicht dargestellten Transistorkombinationen sind links und rechts von T1, T2 und T3, T4 auf weiteren Teilen des Halbleiterkörpers 1 angeordnet und in analoger Weise mit den Anschlüssen 5, 7 und 13 verbunden. Dabei bilden die Feldeffekttransistoren T2, T4 ... T2n in ihrer Gesamtheit den Treibertransistor und die bipolaren Transistoren T1, T3 ... T(2n-1) in ihrer Gesamtheit den Ausgangstransistor einer Darlington-Schaltung. Die Emittergebiete 3, 14 usw. aller Transistorkombinationen stellen den Emitter des Ausgangstransistors dar, die inselförmigen Halbleitergebiete 2, 18 usw. aller Transistorkombinationen die Basis des Ausgangstransistors, die Sourcegebiete 8 usw. der Transistoren T2, T4 ...T2n in ihrer Gesamtheit das Sourcegebiet des Treibertransistors, die Schichten 1b und 1c eine den Transistoren T1, T3 ...T(2n-1) gemeinsame Kollektorschicht und zugleich ein den Transistoren T2, T4...T2n gemeinsames Draingebiet.

Der laterale Abstand zwischen einem Emittergebiet, z.B. 3, und einem mit diesem in ein und demselben inselförmigen Halbleitergebiet, z.B. 2, vorgesehenen Sourcegebiet, z.B. 8, ist kleiner gewählt als die Dicke des Halbleiterkörpers 1 zwischen den beiden Hauptflächen 1a und 1d,

welche z.B. 50 - 100 µm beträgt. Die Länge des n-Kanals eines Feldeffekttransistors, z.B. T2, die durch die Breite der an das Sourcegebiet, z.B. 8, angrenzenden Randzone, z.B. 10, bestimmt ist, weist zweckmäßigerweise etwa einen Wert von 0,5 - 1 µm auf. Der laterale Abstand zweier nebeneinander liegender inselförmiger Gebiete, z.B. 2 und 18, voneinander entspricht etwa der Breite eines Sourcegebiets, z.B. 8, und beträgt beispielsweise 10 - 50 µm.

Geht man vom nichtleitenden Zustand der Darlington-Schaltung aus, in dem eine hohe Spannung von z.B. 1000 V zwischen den Anschlüssen 5 und 7 wirksam ist, wobei der Anschluß 7 auf einem positiveren Potential liegt als der auf Bezugspotential befindliche Anschluß 5, und legt an den gemeinsamen Gateanschluß 13 ein positives Potential von z.B. 20 V an, so bildet sich in der Randzone 10 unterhalb der Gateelektrode 11 an der Hauptfläche 1a ·eine Inversionsschicht aus, die einen leitenden Kanal zwischen dem Sourcegebiet 8 und dem Draingebiet 1b,1c darstellt. Über diesen fließt ein Strom $I_{B1}$ vom Anschluß 7 zum Sourcegebiet 8 und von diesem über die leitende Belegung 9 zum Basisgebiet 2 des Transistors T1. Als Folge davon entsteht in T1 ein Kollektorstrom $I_{C1}$, der von 7 zum Emittergebiet 3

und über dieses zum Emitteranschluß 5 fließt. Durch den Strom $I_{B1}$, der den Basisstrom von T1 darstellt, gelangen positive Ladungsträger etwa in Richtung des Pfeiles 19 aus dem Gebiet 2 zum pn-Übergang zwischen den Gebieten 2 und 3, was zur Folge hat, daß negative Ladungsträger aus dem Emittergebiet 3 in das Gebiet 2 injiziert werden. Diese bilden zusammen mit weiteren durch $I_{B1}$ in das Gebiet 2 eingeschwemmten positiven Ladungsträgern eine sog. Speicherladung, die sich zunächst unterhalb von 3 im Gebiet 2 aufbaut und sich bei anhaltendem Strom $I_{B1}$ schließlich auch auf die Schicht 1b ausdehnt. Die seitlichen Grenzen der Speicherladung unterhalb von 3 werden durch die gestrichelten Linien 20 und 21 angedeutet. Beim Auftreten der Speicherladung findet sowohl in vertikaler als auch in lateraler Richtung eine Aufweitung der eigentlichen Basiszone von T1 statt, wobei die Leitfähigkeit innerhalb der aufgeweiteten Basiszone 20, 21 wesentlich größer ist als es der Grunddotierung der Schicht 1b entsprechen würde.

Für die im stromführenden Zustand der Transistorkombination T1, T2 zwischen den Anschlüssen 5 und 7 auftretende Restspannung $U_{CE}$ gilt folgende Beziehung:

$$U_{CE} = U_{BE} + \frac{R_{on} \cdot I_{C1}}{\beta} . \qquad\qquad (1)$$

Hierin bedeuten $U_{BE}$ die positive Vorspannung am pn-Übergang zwischen den Gebieten 2 und 3, $R_{on}$ den Durchlaßwiderstand von T2, d.h. den Widerstand der vom Basisstrom $I_{B1}$ durchflossenen Teile 8, 1b und 1c sowie des Inversionskanals in 10, und $\beta$ den Stromverstärkungsfaktor von T1.

Durch das Auftreten der Speicherladung 20, 21 verringert sich $R_{on}$, was bei konstantem Kollektorstrom $I_{C1}$ eine Verringerung von $U_{CE}$ bedeutet. Wird andererseits $U_{C1}$ konstant gehalten, so vergrößert sich durch die Speicherladung der Basisstrom $I_{B1}$, was eine entsprechende Vergrößerung des Kollektorstromes $I_{C1}$ von T1 zur Folge hat.

Analoge Vorgänge laufen beim Anschalten einer Gatespannung von z.B. 20 V an den Anschluß 13 auch in den übrigen Transistorkombinationen T3, T4 ...T(2n-1), T2n ab. Dabei tritt eine Verringerung der Durchlaßwiderstände $R_{on}$ in den einzelnen Transistoren T2, T4...T2n durch die Speicherladungen der Transistoren T1, T3...T(2n-1) auf, was zur Folge hat, daß bei Konstanthaltung des Kollektorstromes $I_C$ der Darlington-Schaltung die Restspannung zwischen den Anschlüssen 5 und 7 einen kleineren Wert annimmt als das bei den herkömmlichen Schaltungen dieser Art der Fall ist. Andererseits wird bei gleicher Restspannung zwischen den Anschlüssen 5 und 7 der maximale Kollektorstrom $I_C$ der Darlington-Schaltung gegenüber den herkömmlichen Schaltungen vergrößert.

Diese Wirkungen können noch dadurch gesteigert werden, daß für jeweils zwei nebeneinander liegende Transistorkombinationen, z.B. T1, T2 und T3, T4, der Durchlaßwiderstand $R_{on}$ des einen Feldeffekttransistors, z.B. T2, nicht nur durch die Speicherladung des zugehörigen bipolaren Transistors, z.B. T1, sondern auch durch die Speicherladung, z.B. 22, 23, des der benachbarten Transistorkombination, z.B. T3, T4, zugeordneten bipolaren Transistors, z.B. T3, verringert wird. Das tritt dann ein, wenn sich die betreffenden Speicherladungen gemäß Fig. 1 gegenseitig überlappen. Um eine Überlappung zu erzielen, ist es

zweckmäßig, den lateralen Abstand zwischen den Emittergebieten, z.B. 3 und 14, zweier einander benachbarter bipolarer Transistoren, z.B. T1 und T3, so zu wählen, daß er etwa dem doppelten lateralen Abstand zwischen dem Emittergebiet eines dieser bipolaren Transistoren, z.B. T1, und dem Draingebiet des diesem zugeordneten Feldeffekttransistors, z.B. T2, entspricht.

Fig. 2 zeigt ein Ausführungsbeispiel der Erfindung, bei dem das inselförmige Halbleitergebiet 2 außer dem Emittergebiet 3 des Ausgangstransistors und dem bereits beschriebenen Sourcegebiet 8 des Transistors T2 ein zweites Sourcegebiet 24 enthält, das mit einer leitenden Belegung 25 versehen ist, die in Richtung auf das Gebiet 3 derart verlängert ist, daß sie den pn-Übergang zwischen 24 und 2 überragt und das Gebiet 2 kontaktiert. Eine Randzone 26 des Gebiets 2, die sich bis zur Hauptfläche 1a und bis an den linken Rand des Sourcegebiets 24 erstreckt, wird von einer Gateelektrode 27 überdeckt, die durch eine dünne elektrisch isolierende Schicht 28 von der Hauptfläche 1a getrennt ist. Die Gateelektrode 27 ist zusammen mit den bisher beschriebenen Gateelektroden 11 und 16 an den gemeinsamen Gateanschluß 13 gelegt. In Fig. 2 sind die bereits beschriebenen Teile mit den gleichen Bezugszeichen versehen wie in Fig. 1. Der aus den Teilen 24, 26, 1b, 1c, 27, 28 und 25 gebildete Feldeffekttransistor T2a dient ebenso wie der Feldeffekttransistor T2 zur Ansteuerung von T1. In entsprechender Weise ist ein weiterer Feldeffekttransistor T4a am linken Rand des inselförmigen Halbleitergebiets 18 angeordnet, über den der Transistor T3 angesteuert wird. Zweckmäßigerweise ist die Gateelektrode 11 den Transistoren T2 und T4a gemeinsam. Auch die übrigen Transistorkombinationen weisen jeweils einen zusätzlichen Feldeffekttransistor auf.

Bei diesem Ausführungsbeispiel ergibt sich ein höherer schaltbarer Kollektorstrom $I_C$ als bei Fig. 1, da die Speicherladungen unterhalb der Emittergebiete, z.B. 3, des Ausgangstransistors jeweils die Durchlaßwiderstände $R_{on}$ bei-

der Feldeffekttransistoren, z.B. T2 und T2a, verringern, die an den Rändern des zugehörigen inselförmigen Halbleitergebiets, z.B. 2, angeordnet sind. Die anhand von Fig. 1 erläuterten Bemessungsregeln für den lateralen Abstand des Sourcegebiets eines Feldeffekttransistors vom Emittergebiet des zugehörigen Ausgangstransistors sowie für den lateralen Abstand der inselförmigen Halbleitergebiete voneinander gelten auch für die Struktur nach Fig. 2.

Nach einer bevorzugten Ausgestaltung der Erfindung wird die Breite b eines der Emittergebiete des Ausgangstransistors, z.B. 3, gemessen in Richtung auf das benachbarte Emittergebiet, z.B. 14, dieses Transistors kleiner gewählt als der laterale Abstand zwischen diesen Gebieten. In Fig. 1 beträgt b etwa 1/4 dieses Abstandes. Insbesondere bei Hochspannungstransistoren tritt eine so starke Auffächerung der Kollektorstrompfade der Transistoren T1, T3...T(2n-1) in lateraler Richtung auf, daß für n Transistorkombinationen eine sich aus der Verkleinerung von b ergebende Verringerung der Hauptfläche des Halbleiterkörpers 1 ausgenutzt werden kann, ohne eine nennenswerte Verringerung des maximal zulässigen Kollektorstromes $I_C$ in Kauf nehmen zu müssen. Insbesondere kann die Breite b vorteilhafterweise ohne wesentliche Verringerung des maximal zulässigen Kollektorstromes $I_C$ um etwa eine Größenordnung kleiner gewählt werden als der genannte laterale Abstand. Bei einem solchen Abstand von z.B. 100 µm kann die Breite b z.B. auf 10 µm reduziert werden. Bei herkömmlichen Darlington-Schaltungen beträgt die Breite eines Emitters des Ausgangstransistors demgegenüber 100 - 200 µm. Die Breite der Sourcegebiete, z.B. 8, des Treibertransistors wird der Breite der Emittergebiete des Ausgangstransistors zweckmäßigerweise angeglichen.

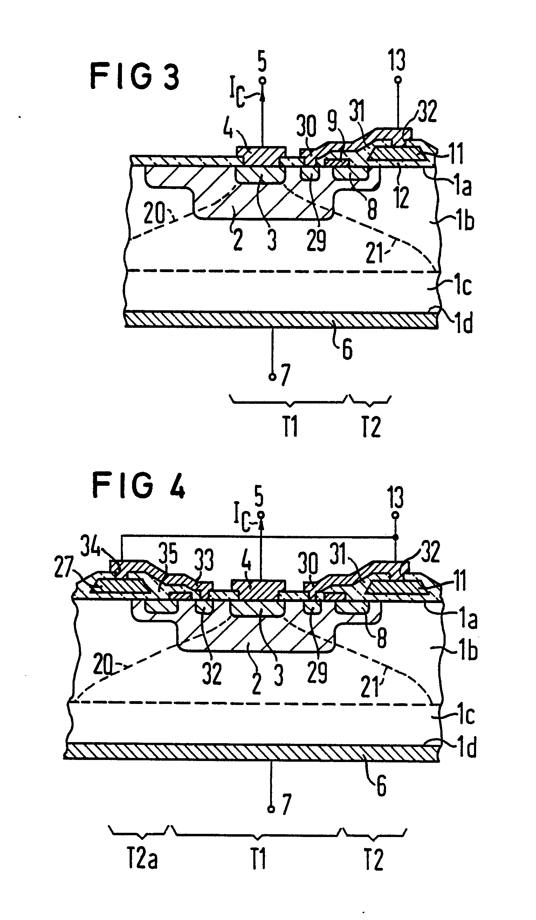

In Fig. 3 ist eine besonders vorteilhafte Weiterbildung der Erfindung dargestellt, bei der in wenigstens eine, vorzugsweise jedoch in alle Transistorkombinationen, z.B. T1, T2, jeweils neben dem Emittergebiet, z.B. 3, des Ausgangstransistors ein $n^+$-dotiertes Halbleitergebiet 29 in das inselförmige Halbleitergebiet, z.B. 2, eingefügt wird, das sich bis zur Hauptfläche 1a hin erstreckt. Jedes dieser Halbleitergebiete ist mit einer leitenden Belegung 30 versehen, die mit einem Anschluß verbunden ist, an den beim Abschalten der Darlington-Schaltung eine negative Spannung angelegt wird. Mit besonderem Vorteil kann hierfür der Anschluß 13 verwendet werden. In diesem Fall ist die leitende Belegung auf einer Zwischenisolationsschicht 31 angeordnet und soweit verlängert, daß sie die mit 13 verbundene Gateelektrode 11 im Bereich eines Fensters 32 der Schicht 31 kontaktiert. Das Gebiet 29 bildet mit dem inselförmigen Halbleitergebiet 2 eine Ausräumdiode, die beim Anschalten einer negativen Spannung an den Anschluß 13, d.h. beim Abschalten des Kollektorstromes $I_C$, leitend geschaltet wird und einen beschleunigten Abbau der Speicherladungen, z.B. 20, 21, bewirkt. Damit wird die Speicherzeit $t_s$, die als die Zeitspanne definiert ist, nach der beim Absenken des Basisstroms der Kollektorstrom ebenfalls abzunehmen beginnt, erheblich verkürzt. Die integrierte Ausräumdiode 2, 29, 30 hat gegenüber einer bei Darlington-Schaltungen in bekannter Weise verwendeten externen Ausräumdiode den wesentlichen Vorteil, daß für ihren Anschluß nur eine leitende Belegung 30 benötigt wird, wogegen eine externe Ausräumdiode zwei Anschlußleitungen erfordert und den Raumbedarf der Darlington-Schaltung wesentlich stärker erhöht.

Die Ausräumdiode 2, 29, 30 ist dann besonders wirkungsvoll, wenn sie in den einzelnen Transistorkombinationen jeweils zwischen dem Emittergebiet, z.B. 3, des Ausgangstransistors und dem Sourcegebiet, z.B. 8, des zugehörigen Feldeffekttransistors, z.B. T2, angeordnet ist. Je größer die Anzahl der Transistorkombinationen ist, die mit einer Ausräumdiode 2, 29, 30 ausgestattet sind, desto kleiner wird die Speicherzeit $t_s$, da um so mehr Transistorkombinationen gleichzeitig von ihren Speicherladungen befreit werden.

Fig. 4 zeigt die Anwendung der vorstehend beschriebenen Weiterbildung auf ein Ausführungsbeispiel nach Fig. 2. Hier ist neben der Ausräumdiode 2, 29, 30 eine weitere analog aufgebaute Ausräumdiode vorgesehen, die aus einem $n^+$-dotierten Halbleitergebiet 32 besteht, das mit einer leitenden Belegung 33 versehen ist. Die Belegung 33 kontaktiert im Bereich des Fensters 34 einer Zwischenisolationsschicht 35 die Gateelektrode 27 des Feldeffekttransistors T2a. Durch die Anordnung einer zweiten Ausräumdiode in einem inselförmigen Halbleitergebiet wird das Ausräumen der Speicherladungen, z.B. 20, 21, beim Abschalten des Kollektorstromes weiter beschleunigt.

Die Integration von Ausräumdioden 2, 29, 30 und ggf. 2, 32, 33 erfolgt mit besonderem Vorteil bei solchen Ausführungsformen der Erfindung, bei denen die Breite der Emittergebiete, z.B. 3, des Ausgangstransistors wesentlich kleiner gewählt ist als der laterale Abstand zwischen zwei solchen Gebieten, z.B. 3 und 14. Dabei kann b um eine Größenordnung kleiner bemessen sein als dieser Abstand.

Neben den bisher beschriebenen Ausführungsformen der Erfindung sind auch solche von Interesse, bei denen die bisher genannten Halbleitergebiete jeweils durch solche des entgegengesetzten Leitfähigkeitstyps ersetzt sind, wobei anstelle der bisher genannten Spannungen bzw. Ströme solche des jeweils entgegengesetzten Vorzeichens verwendet werden.

**Ansprüche**

1. Darlington-Schaltung mit einem Feldeffekttransistor und einem bipolaren Ausgangstransistor, die auf einem Halbleiterkörper eines ersten Leitfähigkeitstyps integriert sind, bei der die Integration des Feldeffekttransistors in der Weise vorgenommen ist, daß ein inselförmiges Halbleitergebiet eines zweiten Leitfähigkeitstyps in den Halbleiterkörper eingefügt ist, daß ein Sourcegebiet des ersten Leitfähigkeitstyps in das inselförmige Halbleitergebiet eingebettet ist und daß das inselförmige Halbleitergebiet eine sich bis zu einer ersten Hauptfläche des Halbleiterkörpers und bis an den Rand des Sourcegebiets erstreckende Randzone aufweist, die von einer Gateelektrode überdeckt wird, bei der das Sourcegebiet mit der Basis des Ausgangstransistors verbunden ist, bei der der Emitter des Ausgangstransistors mit einem Emitteranschluß versehen ist, und bei der der Halbleiterkörper mit einem Kollektoranschluß versehen ist, der zugleich den Drainanschluß des Feldeffekttransistors bildet, **dadurch gekennzeichnet,** daß der Emitter des Ausgangstransistors aus einer Mehrzahl von Emittergebieten (3) des ersten Leitfähigkeitstyps besteht, die mit an den Emitteranschluß (5) gelegten, auf der ersten Hauptfläche (1a) befindlichen Emitterkontakten (4) versehen sind, daß eine Mehrzahl von inselförmigen Halbleitergebieten (2) vorgesehen sind, von denen jedes wenigstens ein Sourcegebiet (8) des Feldeffekttransistors und ein Emittergebiet (3) des Ausgangstransistors enthält, so daß es zusätzlich eines von mehreren Basisgebieten des Ausgangstransistors bildet, daß die Sourcegebiete (8) eines inselförmigen Halbleitergebiets (2) mit elektrisch leitenden Belegungen (9) versehen sind, die das letztere kontaktieren, daß jedes inselförmige Halbleitergebiet (2) eine der Anzahl der in ihm enthaltenen Sourcegebiete (8) entsprechende Anzahl von Randzonen (10) aufweist, die von gegen die erste Hauptfläche (1a) elektrisch isolierten Gateelektroden (11) überdeckt werden, daß die Gateelektroden (11) an einen gemeinsamen Gateanschluß (13) geschaltet sind und daß der laterale Abstand zwischen einem Emittergebiet (3) und einem Sourcegebiet (8) innerhalb eines inselförmigen Halbleitergebiets (2) kleiner ist als die Dicke des Halbleiterkörpers zwischen der ersten Hauptfläche (1a) und einer zweiten Hauptfläche (1d), auf der sich ein mit dem Kollektoranschluß (7) verbundener Kollektorkontakt (6) befindet.

2. Darlington-Schaltung nach Anspruch 1, **dadurch gekennzeichnet**, daß der Halbleiterkörper (1) aus einer ersten, schwach dotierten Schicht (1b) des ersten Leitfähigkeitstyps und einer unter dieser liegenden zweiten Schicht desselben Leitfähigkeitstyps besteht, die stärker dotiert ist als die erste und mit dem Kollektorkontakt versehen ist.

3. Darlington-Schaltung nach Anspruch 1 oder 2, **dadurch gekennzeichnet**, daß zwischen jeweils zwei Emittergebieten (3, 14) des Ausgangstransistors ein Sourcegebiet (8) des Feldeffekttransistors angeordnet ist, das in dasselbe inselförmige Halbleitergebiet (2) eingefügt ist wie das eine (3) der beiden Emittergebiete.

4. Darlington-Schaltung nach Anspruch 1 oder 2, **dadurch gekennzeichnet**, daß zwischen jeweils zwei Emittergebieten (3, 14) des Ausgangstransistors zwei Sourcegebiete (8, 14a) vorgesehen sind, von denen das eine (8) in dasselbe insel förmige Halbleitergebiet (2) eingefügt ist, wie das eine (3) der beiden Emittergebiete und das andere (14a) in dasselbe inselförmige Halbleitergebiet (18) eingefügt ist wie das andere (14) der beiden Emittergebiete.

5. Darlington-Schaltung nach einem der Ansprüche 1 bis 4, **dadurch gekennzeichnet**, daß die Breite (b) eines Emittergebiets (3) des Ausgangstransistors, gemessen in Richtung auf ein benachbartes Emittergebiet (14) dieses Transistors, kleiner ist als der laterale Abstand zwischen diesen beiden Emittergebieten (3, 14).

6. Darlington-Schaltung nach Anspruch 5, **dadurch gekennzeichnet**, daß die Breite (b) eines Emittergebiets (3) des Ausgangstransistors, gemessen in Richtung auf ein benachbartes Emittergebiet (14) dieses Transistors, um eine Größenordnung kleiner ist als der laterale Abstand zwischen diesen beiden Emittergebieten (3, 14).

7. Darlington-Schaltung nach einem der vorhergehenden Ansprüche, **dadurch gekennzeichnet,**daß neben wenigstens einem, vorzugsweise aber neben allen, Emittergebieten (3) des Ausgangstransistors wenigstens ein Halbleitergebiet (29) des ersten Leitfähigkeitstyps in das das Emittergebiet (3) enthaltende inselförmige Halbleitergebiet (2) eingefügt ist, das sich bis zur ersten Hauptfläche (1a) erstreckt und eine leitende Belegung (30) aufweist, die mit einem zur Abschaltung der Darlington-Schaltung mit einer Spannung beaufschlagbaren Anschluß verbunden ist.

8. Darlington-Schaltung nach Anspruch 7, **dadurch gekennzeichnet**, daß der zur Abschaltung der Darlington-Schaltung mit einer Spannung beaufschlag bare Anschluß aus dem gemeinsamen Gateanschluß (13) besteht.

# FIG 1

# FIG 2

**FIG 3**

I_C 5    13

4   30  9  31  32
11
1a
20          1b
2  3  29      21
1c
1d
6
7

T1    T2

**FIG 4**

I_C 5    13

34  35  33  4  30  31  32
27                        11
1a
20          1b
32  2  3  29      21
1c
1d
6
7

T2a    T1    T2

Europäisches Patentamt

**EUROPÄISCHER RECHERCHENBERICHT**

Nummer der Anmeldung

EP 85 11 0689

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 089 527 (BOSCH) <br><br> * Ansprüche 1,5; Figur 4 * <br><br> --- | 1,2,5,6 | H 01 L 27/08 <br> H 01 L 27/06 |
| A | US-A-4 402 003 (BLANCHARD) <br> * Zusammenfassung; Figuren 2,3 * <br><br> --- | 2,7,8 | |
| P,A <br> D | MICROELECTRONICS AND RELIABILITY, Band 24, Nr. 2, 1984, Seiten 313-337, Pergamon Press Ltd., Oxford, GB; P. LETURCQ: "Power bipolar devices" <br> * Seite 335, Figur 18 * <br><br> ----- | 1 | |

| RECHERCHIERTE SACHGEBIETE (Int. Cl.4) |
|---|
| H 01 L |

Der vorliegende Recherchenbericht wurde für alle Patentansprüche erstellt.

| Recherchenort | Abschlußdatum der Recherche | Prüfer |
|---|---|---|
| DEN HAAG | 18-11-1985 | BAILLET B.J.R. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82